# EUROPEAN PATENT SPECIFICATION

(11) **EP 3 559 306 B1**
(45) Date of publication and mention of the grant of the patent: **05.10.2022**
(21) Application number: 17822189.1
(22) Date of filing: 07.12.2017
(51) Int. Cl.: C23C 14/24, C23C 14/20, C23C 14/56, C23C 14/26, C23C 14/06, H01L 31/18, H01L 31/032, H01L 21/02

(54) **LINEAR SOURCE FOR VAPOR DEPOSITION WITH AT LEAST THREE ELECTRICAL HEATING ELEMENTS**
LINEARE QUELLE ZUR GASPHASENABSCHEIDUNG MIT MINDESTENS DREI ELEKTRISCHEN HEIZELEMENTEN
SOURCE LINÉAIRE DESTINÉE AU DÉPÔT EN PHASE VAPEUR DOTÉE D'AU MOINS TROIS ÉLÉMENTS CHAUFFANTS ÉLECTRIQUES

(30) Priority: 22.12.2016 EP 16206110
(43) Date of publication of application: 30.10.2019
(73) Proprietor: Flisom AG, 8155 Niederhasli (CH)
(72) Inventor: KAELIN, Marc, 8155 Niederhasli (CH)
(86) International application number: PCT/EP2017/081917
(87) International publication number: WO 2018/114373

(56) References cited:
- WO-A1-2014/156750
- WO-A1-2017/173875
- JP-A- 2012 132 049
- KR-A- 20120 059 185
- KR-A- 20130 137 400
- KR-A- 20160 007 930
- US-A1- 2005 126 493
- US-A1- 2005 150 975
- US-A1- 2005 208 216
- US-A1- 2006 130 766
- US-A1- 2010 206 865
- US-A1- 2011 067 998
- US-A1- 2011 232 762
- US-A1- 2014 109 829
- US-A1- 2016 047 033
- US-B1- 6 372 538
- US-B1- 6 893 939

## Description

### Field of the invention

The present invention relates to linear evaporation sources used for vapor deposition of material onto substrates and more particularly for controlled material coating of large substrates, such as vacuum deposition on large sheets or using roll-to-roll processes.

In particular, the present invention relates to linear evaporation sources usable for vapor deposition of In, Ga and Cu for controlled material coating of large flexible substrates in vacuum using the roll-to-roll process for the production of thin films of CIGS (Cu(In,Ga)Se2, copper indium gallium di selenide).

The deposition of thin films of CIGS (CuInGaSe2, copper indium gallium di selenide) onto a flexible substrate is an important process step in the industrial manufacturing of solar panels and photovoltaic cells, which convert solar energy into electrical energy basing on the specific physical properties of said CIGS thin film.

In the following, CIGS thin film means a CIGS film exhibiting a thickness between 50 and 0.1 micrometers, most preferably between 5 and 0.5 micrometers.

### Background of the invention

Coating of objects using thermal evaporation requires a crucible to heat up and vaporize material that deposits itself onto a substrate. The deposition usually takes place within a vacuum chamber, thereby imposing spatial and physical constraints. Space may be especially constrained in the case of roll-to-roll deposition where the roll-to-roll mechanism must be contained within a desirably small vacuum chamber. Physical constraints are also strong in the case of coevaporation using multiple adjacent sources operating at different regulated temperatures to deposit material with a desired distribution and thickness onto a moving substrate.

A source for vapor deposition of material onto a roll-to-roll web ordinarily comprises: an elongated crucible that contains the material to be vaporized, at least one electrical heating element, and optionally nozzles to direct the vaporized material flux onto the nearby moving web substrate. Several evaporation sources, also known as evaporation boats, may be arranged parallel to each other to deposit larger quantities of material and/or different materials onto the moving substrate.

It is often necessary to regulate the flux of material leaving the crucible to achieve a controlled deposition thickness along the length and the width of the moving substrate. The flux of material and its distribution is related to the crucible's temperature distribution and also to the distribution and shape of the openings or nozzles that let the evaporated material flow out of the crucible. The temperature distribution within a crucible is ordinarily spatially non-uniform, and therefore related to the electrical power delivered to the heating elements at various locations within the evaporation source's assembly. U.S. patent 2,440,135 (also published as G.B. patent application 554,312) describes an apparatus for thermal evaporation in vacuum chambers comprising a container that itself comprises a metal tube extending across the container in the path of flow of the vapor to the nozzle structure, said metal tube being traversed by an electric resistance heater. European patent application EP1662017A1 (also published as U.S. Pat. App. No. 2006/0291825A1) describes an arrangement for vaporizing materials comprising three heating circuits, two of which are provided to regulate the longitudinal distribution of temperature by independently and externally heating two halves of the crucible's vaporizer tube. Japanese patent application JP 2005-13673 (also published as U.S. Pat. App. No. 2009/0173279A1) describes a crucible divided into a plurality of independently heated regions located under the crucible's lower surface. Further relevant prior art is disclosed in patent document US 6 893 939 B1.

### Summary of the invention

A problem in the field of thermal vapor deposition relates to the regulation of the thickness distribution of the material layers deposited on a substrate using evaporation sources. This problem is especially acute with large substrates. It is therefore an object of the current invention to provide an evaporation source that enables spatial regulation of material deposited on a moving substrate such as a roll-to-roll web substrate.

Another problem in the field of thermal vapor deposition relates to the limited volume of the vacuum chambers where evaporation takes place, thereby imposing spatial constraints on the size of the sources used, the energy they consume and radiate, and their influence on the reliability of the entire vacuum deposition system. It is therefore a further object of the current invention to provide an evaporation source that is compact but whose design can readily be lengthened by a person ordinarily skilled in the art, can be combined into an array of sources, and enables fast regulation of material deposition with the benefits of low energy consumption, increased longevity, and reduced costs.

A further problem in the field of thermal vapor deposition relates to the efficiency of the deposition with respect to evaporated material consumption and especially to the changes in efficiency as the level within the evaporation source of material to be evaporated changes. It is therefore also a further object of the current invention to provide an evaporation source that consumes less material and energy than conventional evaporation sources to achieve a uniform deposition and to provide an evaporation source that can adapt to changes within the evaporation source of the level of material to be evaporated.

Different pressure in the evaporation source will affect the deposition profile. An object of the present invention is also therefore to provide an evaporation source where the deposition profile can be adapted to the background pressure in the evaporation source.

Yet a further problem in the field of thermal vapor deposition relates to the undesired deposition of material droplets, also known as spitting, onto the substrate. It is therefore yet a further object of the current invention to provide an evaporation source that reduces or prevents problems associated with spitting or projection of material droplets.

Also, a further problem in the field of thermal vapor deposition during long deposition cycles relates to the falling of material flakes or other particles into the evaporation source. It is therefore also an object of the current invention to provide an evaporation source that prevents problems associated with falling material flakes.

The invention thus pertains to a long high-temperature high-output linear evaporation source apparatus for vapor deposition applications, comprising at least one elongated horizontal crucible for containing, up to a given level in the crucible, material to be melted and evaporated, and a heater assembly comprising at least three electrical heating elements.

In the following, long linear evaporation source means an evaporation source longer than 40 cm, preferably longer than 60 cm, more preferably longer than 80 cm, so as to be suited to coat wide webs and foils in an industrial roll-to-roll manufacturing coating step.

Linear evaporation source means an evaporation source exhibiting a length considerably larger than the width and the height of the evaporation source. The length of the evaporation source can be 3 times, preferably 7 times, more preferably 10 times larger than the width and the height of the evaporation source.

In the following, high temperature evaporation source means an evaporation source suited to evaporate metals with evaporation temperature higher than 600°C, preferably higher than 700°C, most preferably higher than 800°C, so as to be suited to evaporate for example In (evaporation temperature 900°C), or Ga (evaporation temperature 1000°C), or Cu (evaporation temperature 1300°C) in an industrial roll-to-roll manufacturing coating step.

In the following, high output evaporation source means an evaporation source capable to depose per unitary length a material flux higher than 5 nm cm/s, preferably higher than 100 nm cm/s, most preferably higher than 150 nm cm/s, so as to be suited to coat large webs and foils in an industrial roll-to-roll manufacturing coating step with acceptable speed. During the production of CIGS thin films, the pressure of the atom gas in the evaporation source is between 10⁻² and 10⁻⁴ mBar. The pressure of the atom gas outside the evaporation source close to the deposition substrate is between 10⁻⁴ and 10⁻⁶ mBar. The invention is defined by the appended claims.

The evaporation source apparatus of the invention is characterized by the following features:
(a) each electrical heating element is supplied by electrical lines arranged to enable independent regulation of said heating elements and wherein for N heating elements there are at least N+1 supply lines;
(b) at least one of the heating elements constitutes a principal heating element that is positioned inside the volume of the crucible, and extends along and parallel to the longest centerline of the crucible, above the level of material to be evaporated; and
(c) at least one further heating element is positioned inside or outside the crucible at each end of the longest centerline of the crucible and at each end of said principal heating element.

The apparatus according to the invention enables a more even spatial distribution of the deposited material with less energy expense and the possibility to regulate an evaporation profile, as will be explained in greater detail later.

During normal operation, the crucible is normally closed, preferably by at least one removable lid.

A person of ordinary skill in the art will recognize that any appropriate material may be deposited on a substrate using the long high-temperature high-output linear evaporation source apparatus for vapor deposition applications according to the invention. The vapor deposition source is particularly appropriate for deposition of materials to create photovoltaic cells, particularly CIGS (copper-indium-gallium-selenide) solar cells. In one example, at least one CIGS containing semiconductive photovoltaic layer, also known as the absorber layer, is deposited onto a portion of a web. The semiconductive photovoltaic layer may, for example, be made of an "ABC" material, wherein "A" represents elements in group 11 of the periodic table of chemical elements (e.g., copper (Cu) or silver (Ag)), "B" represents elements in group 13 of the periodic table (e.g., indium (In), gallium (Ga), or aluminum (Al)), and "C" represents elements in group 16 of the periodic table (e.g., sulfur (S), selenium (Se), or tellurium (Te)). An example of an ABC2 material is the Cu(In,Ga)Se2 semiconductor also known as a CIGS material. Further elements may be added as a dopant such as Na and K.. Other thin-film absorber materials include cadmium telluride (CdTe) and its variants, amorphous silicon, thin-film silicon, as well as absorber materials used to manufacture dye-sensitized solar cells or organic solar cells, CZTS (copper zinc tin selenide) and perovskite materials.

The apparatus preferably comprises at least one nozzle on a face of the apparatus that is parallel to the longest centerline of the crucible, said at least one nozzle having a flux-wise axis that is oriented at between +30 degrees and +150 degrees with respect to the plane supporting the base of at least one nozzle.

In this case, there is no line of sight from outside the evaporation source apparatus to the material to be evaporated through the nozzles, said line of sight being obstructed by the heating element assembly.

In alternative embodiments, there can be a single nozzle in the form of a slit extending along a substantial portion of the full length of the crucible, or a plurality of nozzles distributed uniformly or non-uniformly along substantially the full length of the crucible. The plurality of nozzles can be slits, holes or a combination of slits and holes. The slits can have uniform or varying width, for example narrower in the middle and wider towards the ends.

In the inventive apparatus, at least one heating element that is positioned inside the volume of the evaporation source apparatus is supported at at least one location that is not part of one of the faces through which the longest centerline of the crucible passes.

Conveniently, at least one heating element is an electrically heatable rod or an electrically heatable coil, in both cases made of an electrically-conductive and heat-resistant material, in particular tantalum, graphite, tungsten, or molybdenum.

In the inventive apparatus, the principal heating element and at least one further heating element are preferably axially aligned and at least one electrical contact of one of the heating elements passes through and is parallel to the axis of symmetry formed by the shape of one of the heating elements.

At least two heating elements can be separated from each other by electrical insulators made of refractory material.

The crucible advantageously contains at least one temperature sensor for each independently-regulated heating element, the temperature sensor being positioned against a part of the crucible that is adjacent to a volume of material to be evaporated that is heated by the respective closest heating element.

Furthermore, the crucible may comprise at least one temperature sensor channel for receiving at least one temperature sensor such that said temperature sensor channel is positioned under a part of the crucible that is adjacent to a volume of material to be evaporated, the temperature sensor channel having an opening located on at least one of the faces of the apparatus through which the longest centerline of the crucible passes.

The apparatus can further comprise at least one heat shield assembly that at least partially surrounds the crucible. In this case, an external opening of a nozzle can protrude through and beyond the thickness of the heat shield assembly adjacent to the nozzle. Moreover, at least one lip pair can join the crucible with a lid such that said lip pair extends through the heat shield assembly and is equal or greater than the total thickness of the heat shield assembly at the edge of the lip pair.

Overall, the heating elements can be made independently controllable by a control system in response to information acquired from at least one temperature sensor.

The invention's features advantageously solve several problems in the field of thermal vapor deposition, namely:
- The at least N+1 electrical supply lines enable independent regulation of heating elements while advantageously offering the possibility to minimize the number and size of electrical supply lines with the further benefit of energy savings,
- The at least one principal heating element that is positioned inside the volume of the crucible, and extends along and parallel to the longest centerline of the crucible, above the level of material to be evaporated, advantageously reduces the evaporation source's volume and heats the material at the surface where evaporation occurs, thereby permitting a faster response to changes in temperature of the heating elements and subsequent energy savings.
- The at least one further heating element positioned inside or outside the crucible at each end of the longest centerline of the crucible and at each end of said principal heating element advantageously helps solve the problem of uneven spatial distribution of the deposited material and reduce energy expense to obtain a uniform deposition profile.
- The at least one nozzle having a flux-wise axis that is oriented at between +30 and +150 degrees with respect to the plane supporting the base of at least one nozzle advantageously helps increase the deposition quality over a larger deposition area, especially in the case of roll-to-roll applications where a moving substrate might not be planar.
- The obstruction of the line of sight from outside the evaporation source apparatus to the material to be evaporated through the nozzles by the heating element assembly advantageously prevents: spits of molten material from the crucible towards the substrate, bouncing of condensed droplets thanks to heating of the lid or crucible surface closest to the substrate, and spitting through the nozzles thanks to nozzles lips being heated.
- The preferably axially aligned heating elements advantageously reduce the complexity of external wiring needed to power the heating elements in comparison to configurations found in the prior art, thereby increasing reliability and reducing assembly cost.
- The at least one temperature sensor for each independently-regulated heating element enables better regulation of the deposition process in conjunction with a deposition control system. Alternatively, regulation of the independent heating elements can also be done by monitoring the evaporation flux (EIES, atomic absorption, quartz cristal monitor) or analysis of the coated layer (XRF, EDX)
- The at least one heat shield assembly that at least partially surrounds the crucible advantageously insulates the source and therefore reduces the amount of heat radiated to adjacent objects.
- The external opening of the nozzles protruding through and beyond the thickness of the heat shield assembly advantageously reduces the possibility of material depositing onto the shields.
- The at least one lip pair joining crucible with lid and extending through the heat shield assembly advantageously channels and directs vapor leaks away from the heat shield assembly and preserves the heat shield assembly's insulating properties.
- The control system to regulate the heating elements (or EIES, AAS, XRF, EDX) using information acquired from at least one temperature sensor advantageously helps to: control the temperature of the molten material within the crucible, produce spatially uniform depositions, produce controlled depositions, and regulate heating elements to compensate for changes in deposition resulting from depletion of material within the crucible.

### Brief description of figures

Embodiments of the invention will now be described by way of example, with reference to the accompanying drawings, in which:
FIGS. 1A-1E show in perspective and cross-sectional views an evaporation source comprising a crucible closed by a lid with lip joints, a set of three coaxial heating rods, temperature sensors, nozzles, and heat shields (FIGS. 1D and 1E). Cross-sections 1C and 1E detail the evaporation source of FIGS. 1B and 1D with molten material at the bottom of the crucible.
FIGS. 2A-2E show individual heating coil elements and their mating as a 3-component heating coil assembly placed inside a tube that is then inserted into a crucible comprising temperature sensors and nozzles.
FIGS. 3A-3C show an evaporation source comprising three parallel heating rods, two side heaters, temperature sensors, lid, and nozzles. Alternative embodiments have one and three rows of nozzles.
FIGS. 4A-4D show two different evaporation sources where nozzles are located on the side of the evaporation source, either as part of the crucible's lid or as part of the crucible.
FIG. 5 is a graph comparing deposition profiles when using one or three heating elements.
FIGS. 6A-6B show electrical diagrams of two alternative equivalent circuits for the heating elements of the evaporation sources of FIGS. 1A-4D along with their power supplies.
FIG. 7 shows a schematic diagram of a feedback loop to regulate heaters of the evaporation source.
FIGS. 8A-8B show two exemplary embodiments of vapor deposition systems to illustrate how the evaporation sources may be used.

### Detailed description of specific embodiments

The exemplary embodiments presented in this disclosure show an evaporation source comprising a crucible, itself comprising at least three heating elements, at least one of which is contained within said crucible. The crucible is ordinarily closed by a lid. The heating element located within the crucible is positioned close to the top of the crucible and close to nozzle orifices present either in the lid or near the top of one of the crucible's long walls. Said nozzles may be shaped/oriented so as to direct the vapor flux in a desired direction. This proximity of the inner heating element to the nozzles ensures firstly that the heating elements block the line of sight from outside the evaporation source through the nozzles towards the material to be evaporated, and secondly that the nozzles are heated.

Someone skilled in the art will appreciate that the scales of the various components represented in the figures have been changed to improve clarity. Furthermore, the number and areas of components in the figures can be scaled up. However, the crucible will preferably keep approximately its illustrated configuration and proportions where the crucible is an elongated hollow body of rectangular or trapezoidal cross-section having a substantially flat bottom, a substantially flat top which is larger than the bottom, substantially flat side walls that may be, in the case of a trapezoidal cross-section, slightly inclined outwardly from the bottom to the top, as shown, and relatively small substantially flat rectangular or trapezoidal end walls. The crucible length is normally at least 3 times and preferably at least 5 times or even 8 times longer than its outer width at the top.

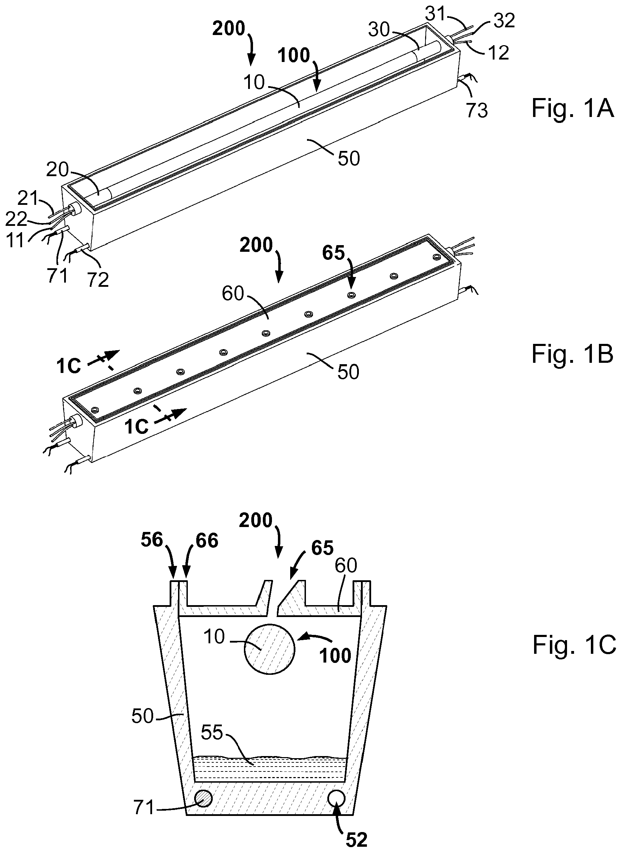

FIGS. 1A-1E present a first embodiment with three longitudinally-aligned coaxial heating rods.

FIG. 1A shows an embodiment of an evaporation source 200 comprising an elongated generally rectangular crucible 50 and a heater assembly 100 composed of three axially aligned heating rods 20, 10, 30. Heater assembly 100 is supported at each end by passing through a support hole in each short face of crucible 50 and positioned close to the crucible's opening or top so that there is no contact between said heater assembly and molten material 55 to be evaporated present at the bottom of crucible 50 during ordinary operation. Heating rods 10, 20, and 30 are powered via pairs of insulated contacts 11, 12, 21, 22, and 31, 32, respectively. Evaporation source 200 comprises at least three temperature sensors 71, 72, 73 positioned against or, as shown in Fig. 1C, inside the thickness of, the lower surface of crucible 50. Each temperature sensor 71, 72, 73 preferably extends so as to provide temperature of the material to be evaporated at a position situated under the mid-length of each heating rod 10, 20, 30 of heater assembly 100, respectively.

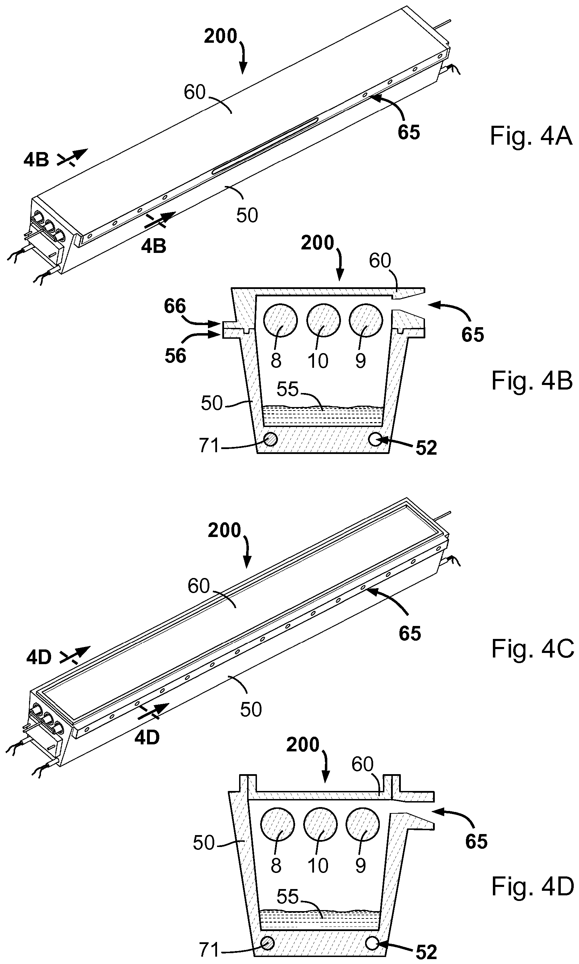

FIG. 1B shows a preferred embodiment of the evaporation source 200 of FIG. 1A where crucible 50 is closed by lid 60. Crucible 50 and lid 60 are ordinarily made of a refractory material for example primarily containing alumina (Al₂O₃), silica, boron nitride, graphite, molybdenum, tantalum, or tungsten. Lid 60 comprises at least one nozzle 65 positioned over heater assembly 100. Lid 60 preferably comprises a plurality of nozzles 65 wherein no nozzle 65 provides a line of sight from outside crucible 50 to the surface of the material to be evaporated contained within crucible 50. Furthermore, although the nozzles 65 may ordinarily be designed so as to direct the evaporated flux orthogonally to the surface of lid 60, in this embodiment the nozzles are inclined, as shown in the cross-section of FIG. 1C. Although the channel of nozzles 65 is represented as being divergent, someone ordinarily skilled in the art may choose to design a different channel such as straight, convergent, convergent-divergent, differently divergent, and/or as an elongated slit so as to advantageously shape the pattern of material deposition onto the substrate. The cross-section of an embodiment with convergent-divergent nozzles is presented in FIG. 4D. Furthermore, although FIG. 1B presents one row of uniformly distributed nozzles 65, it is also possible to have a non-uniform distribution of nozzles 65, as presented in FIG. 4A.

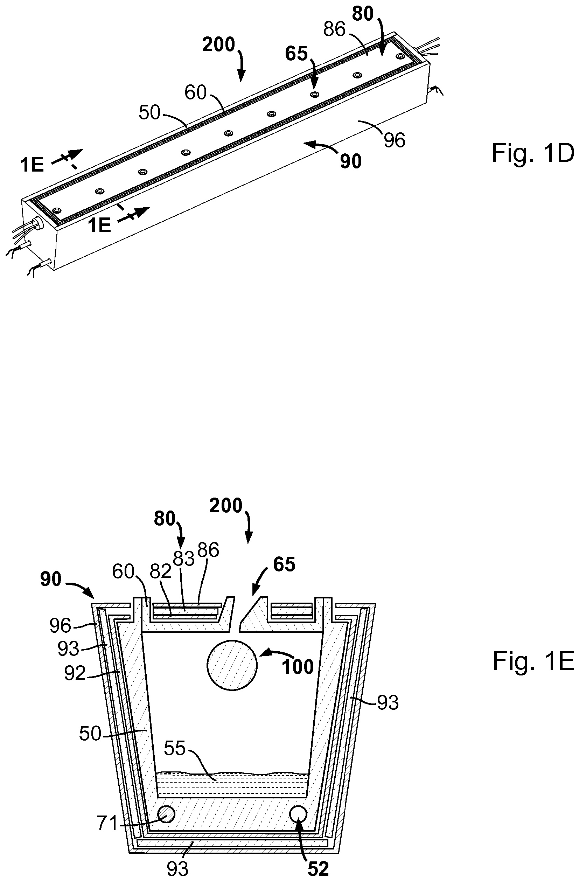

FIG. 1C shows a cross-section of an embodiment of evaporation source 200 of FIG. 1B with molten material to be evaporated 55 at the bottom of crucible 50 occupying typically up to about 20-25% or up to 50% of the crucible's depth without touching any heating element. Lid 60 closes crucible 50. The crucible is ordinarily able to contain an amount of molten material to be evaporated enabling the coating of 2000 meters to 5000 meters of substrate. Heater assembly 100, represented in this cross-section by the centermost or principal heating rod 10, is placed close to nozzles 65 so that no line of sight is established from outside crucible 50 to the surface of molten material 55. Molten material 55 is typically a metal such as copper, indium, gallium, selenium, zinc, tin, gold, chrome, antimony, sodium, magnesium, aluminium, germanium, nickel, silver, cadmium, lead or other materials to be evaporated with a boiling point from 100 degrees Celsius to 2000 degrees Celsius. Temperature sensor 71 is also present in the cross-section of the crucible bottom. Hole 52 serves in this embodiment as a channel for temperature sensor 72 in case there is a need to measure temperatures closer to the mid-length of crucible 50. FIG. 1C illustrates how the channel of nozzle 65 may be designed so as to direct the evaporated flux at an angle that is not orthogonal to the plane of lid 60. The angle at which nozzle 65 is oriented will ordinarily be between +30° and +150° with respect to the plane onto which nozzle 65 is fitted, in the present case the plane of lid 60. FIG. 1C also shows how crucible 50 and lid 60 are provided with respective extended lips 56, 66 at the perimeter where they are in contact. The pair of lips 56, 66 acts as a circumferential joint which may also channel the vapor flux of material 55 that may leak through the pair of lips 56, 66 between crucible 50 and lid 60. Said lips 56, 66 help reduce the amount of material that may deposit on an optional heat shield assembly presented in FIGS.1D-1E.

FIG. 1D shows the preferred embodiment of evaporation source 200 of FIG. 1B surrounded by heat shields comprising lid heat shield assembly 80 and crucible heat shield assembly 90. Said heat shield assemblies 80, 90 are detailed in the cross-section of FIG. 1E. FIG. 1D therefore only shows the outer layer of the heat shield assemblies 80, 90 comprising lid outer shield 86 placed on lid 60 but leaving clearance for nozzles 65, and crucible outer shield 96 wrapped around crucible 50 till the edges of lid 60. Said heat shields advantageously reduce radiation of heat away from the evaporation source, thereby reducing energy consumption and furthermore reducing the amount of heat radiated towards the substrate onto which the material is deposited, and/or towards adjacent components such as other evaporation sources and/or the evaporation source's supporting infrastructure.

FIG. 1E shows a cross-section detailing the heat shield assemblies 80, 90 of the preferred embodiment of evaporation source 200 of FIG. 1D. As in FIG. 1C, evaporation source 200 contains molten material to be evaporated 55 heated by heater assembly 100 within crucible 50 closed by lid 60. Crucible 50 also comprises temperature sensor 71 and temperature sensor channel 52. Said heat shield assemblies 80, 90 comprise at least one shielding layer and are represented in this figure by a three-layer shield assembly. Someone ordinarily skilled in the art will infer that the number, size, thickness, and spacing of shields may be varied. Lid heat shield assembly 80 comprises inner shield 82, middle shield 83, and outer shield 86. Crucible heat shield assembly 90 comprises inner shield 92, middle shields 93, and outer shield 96. A better thermal shielding is usually obtained by providing some separation between shields 82, 83, 86 and 92, 93, 96 so that their surfaces do not contact each other. Inner and outer shields 82, 92, 86, 96 are ordinarily made of high-temperature resistant material such as molybdenum, tantalum, tungsten, niobium, rhenium, or titanium. Middle shields 83, 93 are ordinarily made of a refractory material for example primarily containing alumina (Al₂O₃), silica, boron nitride, or felt made of carbon or graphite.

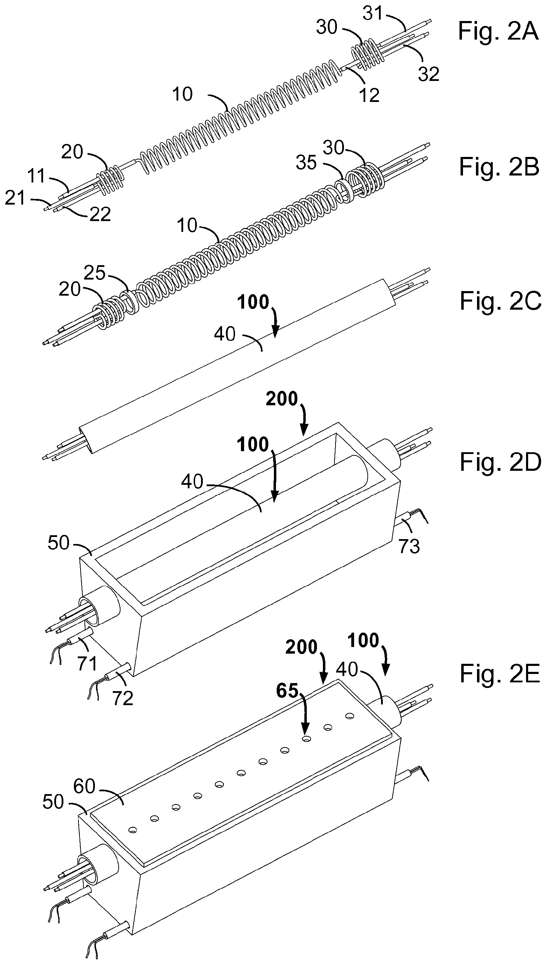

FIGS. 2A-2E present perspective views of a second embodiment with three coaxial axially-aligned heating coils.

FIG. 2A shows an assembly of three axially aligned electrical heating coils 10, 20, 30. The central heating coil 10 is powered at each of its extremities via extended insulated contacts 11, 12. Insulated contacts 11, 12 are located close to the common axis of heating coils 10, 20, 30 and extend in a direction parallel to said common axis. Heating coil 20 is located at one of the extremities of heating coil 10 and surrounds insulated contact 11. Heating coil 30 is located at the other extremity of heating coil 10 and surrounds insulated contact 12. Heating coils 20 and 30 are powered via insulated contacts 21, 22 and 31, 32, respectively. Heating coils 10, 20, 30 may be of the same or different lengths, the same or different diameters, and have the same or different and non-uniform numbers of turns per unit length. In the preferred illustrated example, the central heating coil 10 is longer than the end heating coils 20, 30, all coils having approximately the same diameter.

FIG. 2B shows said assembly of FIG. 2A optionally complemented with electrical insulators 25, 35 in the form of rings or discs positioned between heating coils 20, 10, 30. Electrical insulators 25, 35 are ordinarily made of a refractory non-electrically conducting material for example primarily containing alumina, silica, zirconia toughened alumina, steatite, or mullite.

FIG. 2C shows heater assembly 100 where said assembly of FIG. 2A or FIG. 2B is inserted into electrically insulating heater tube 40. Heater tube 40 is ordinarily made of a refractory, non-electrically conducting material for example primarily containing alumina, silica, zirconia toughened alumina, steatite, or mullite.

FIG. 2D shows an embodiment of an evaporation source 200 comprising a crucible 50, ordinarily an elongated container of trapezoidal cross-section made of refractory material, and a heater assembly 100 aligned with the crucible's long centerline and passing through corresponding holes in each trapezoid short side. Heater tube 40 is positioned close to the crucible's opening or top so that the material to be evaporated, also called a melt, remains at the crucible's bottom and below heater tube 40 during ordinary operation. Evaporation source 200 further comprises at least three temperature sensors 71, 72, 73, such as thermocouples, positioned against the part of crucible 50 containing said melt. Temperature sensors 71, 72, 73 are preferably positioned within dedicated channels inside the thickness of the crucible's lower surface and extend so as to provide temperature of the melt region situated preferably under the mid-length of each heating coil 10, 20, 30 of heater assembly 100, respectively.

FIG. 2E shows a preferred embodiment of the evaporation source 200 of FIG. 2D closed by lid 60. Lid 60 comprises at least one nozzle 65, for example as illustrated a line of nozzles distributed along the length of crucible 50, positioned over heating tube 40 and such that no nozzle 65 provides a line of sight from outside crucible 50 to the surface of said melt.

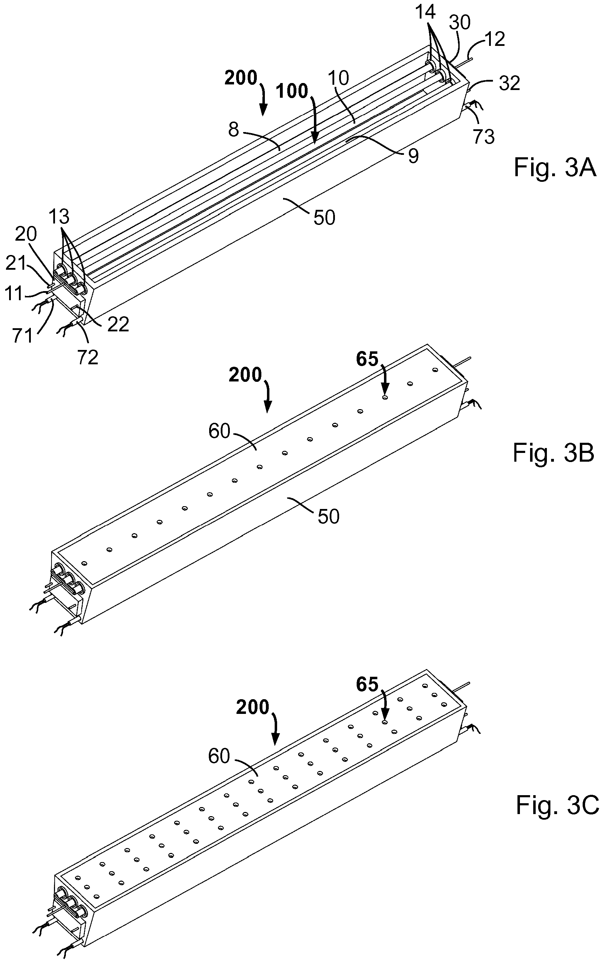

FIGS. 3A-3C present perspective views of the disclosure with three principal parallel heating rods and two external side-end heaters.

FIG. 3A shows an evaporation source 200 comprising a crucible 50 that comprises a heater assembly 100 comprising three parallel heating rods 8, 9, 10 positioned side-by-side along the length of crucible 50. Heating rods 8, 9, 10 are supported at each end by passing through electrically insulating support holes 13, 14 in each short face of crucible 50 and positioned close to the opening or top of crucible 50 so that there is no contact between said heating rods and the liquid melt present at the bottom of crucible 50 during ordinary operation. Heating rods 8, 9, 10 are electrically connected in parallel so as to represent a single heating element and powered via insulated contacts 11, 12. Someone ordinarily skilled in the art will infer that heating rods 8, 9, 10 may also be connected in series or any combination of parallel and series, or that the number of heating rods positioned within crucible 50 and close to its top may be increased. Heating assembly 100 further comprises side heaters 20 and 30 that are mounted outside crucible 50 against each short face and powered by contacts 21, 22 and 31, 32, respectively. It is understood that if the crucible 50 is surrounded by heat shields as in Figs. 1D and 1E, the side heaters 20 and 30 will be located inside the heat shields. Similarly to crucibles 50 of embodiments presented in FIGS. 1B and 2D, crucible 50 comprises at least three temperature sensors 71, 72, 73 positioned against, or inside the thickness of, the lower surface of crucible 50. Temperature sensor 71 preferably extends till the mid-length of heating rods 8, 9, 10. Temperature sensors 72, 73 preferably extend at most one third of the length of heating rods 8, 9, 10.

FIG. 3B shows the evaporation source 200 of FIG. 3A closed by lid 60. Lid 60 comprises at least one nozzle 65, for example as illustrated a line of nozzles distributed along the length of lid 60, positioned over heater assembly 100 and such that no nozzle 65 provides a line of sight from outside crucible 50 to the surface of the melt within said crucible.

FIG. 3C shows an evaporation source 200 of FIG. 3B where lid 60 comprises 3 rows of, in this example fifteen, nozzles 65 distributed along the length of the lid, positioned over heating rods 8, 9, 10 and such that no nozzle 65 provides a line of sight from outside crucible 50 to the surface of the melt within said crucible.

FIGS. 4A-4D present perspective and cross-sectional views of fourth and fifth embodiments where nozzles are located on the side of the source. Said fourth and fifth embodiments are designed for evaporation deposition tasks where the substrate is located or moves along the side of the evaporation source, such as in roll-to-roll coating of flexible substrates.

FIG. 4A shows the fourth embodiment, which is an alternative embodiment of evaporation source 200 of FIG. 3B where crucible 50 has at least one of its long walls cut out so as to support an extended lid 60 bearing at least two faces: a top face and at least one side face. One of the side faces of lid 60 comprises at least one nozzle 65, in this example a line of nozzles comprising a combination of circular and slit nozzles, so arranged that no nozzle 65 provides a line of sight from outside crucible 50 to the surface of the melt 55 within said crucible. FIG. 4A also shows that nozzles 65 are not distributed evenly along the side face of lid 60.

FIG. 4B shows a cross-section of the embodiment of evaporation source 200 of FIG. 4A. It is conceptually similar to the cross-section of FIG. 1C with a crucible 50 containing molten material to be evaporated 55 at its bottom and comprising temperature sensor 71, temperature sensor channel 52, three parallel heating rods 8, 9, 10, and lid 60 bearing nozzles 65. FIG. 4B details how the walls of crucible 50 differ from that of FIG. 1C: the shape of crucible 50 is modified to support lid 60 bearing side-facing nozzles 65. FIG. 4B also shows that the line of sight from outside evaporation source 200 through nozzles 65 towards the material to be evaporated 55 is obstructed by heating rod 9. Evaporation source 200 also comprises extended lips 56, 66 as a provision to reduce deposition of vaporized material 55 onto an optional (not presented in this figure) shield assembly 90 that would be conceptually similar to that presented in FIG. 1E.

FIG. 4C shows an alternative embodiment of evaporation source 200 of FIG. 3B where crucible 50 has a row of nozzles 65 close to the top of one of its side walls. In this embodiment the lid 60 bears no nozzles.

FIG. 4D shows a cross-section of the embodiment of evaporation source 200 of FIG. 4C. It is conceptually similar to the cross-section of FIG. 1C with a crucible 50 containing molten material to be evaporated 55 at its bottom and comprising temperature sensor 71, temperature sensor channel 52, three parallel heating rods 8, 9, 10, and a lid 60 that bears no nozzles. In this embodiment, it is crucible 50 that bears convergent-divergent nozzles 65 close to the top of one of its side walls that runs parallel to heating rod 9. FIG. 4D also shows that the line of sight from outside evaporation source 200 through nozzles 65 towards the material to be evaporated 55 is obstructed by heating rod 9.

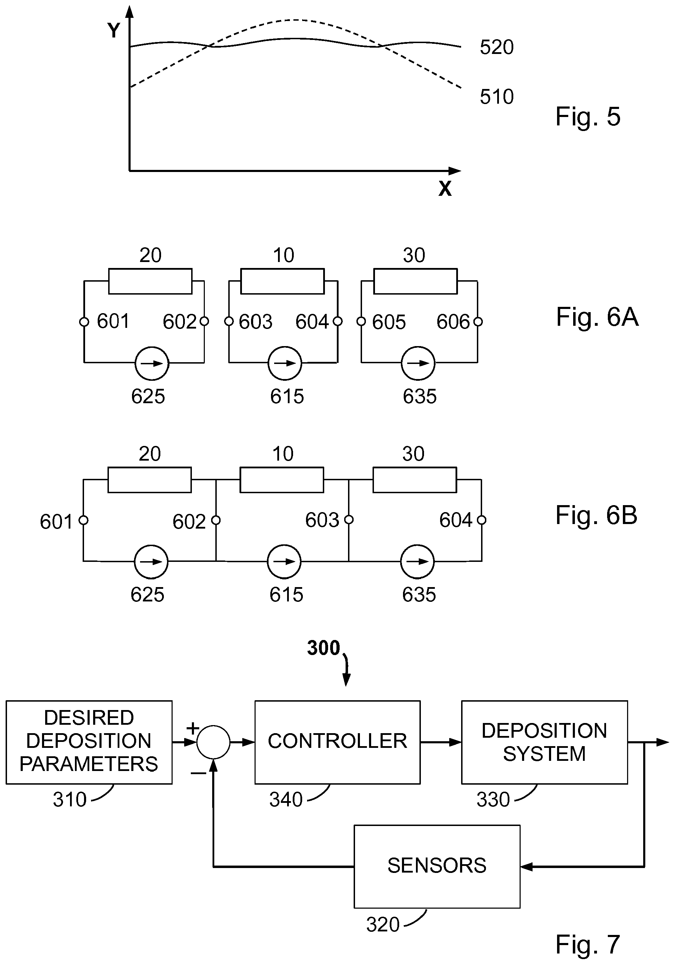

FIG. 5 shows a graph comparing the deposition profile, for example thickness Y of material deposited on a planar substrate, versus position X along the long axis of evaporation source 200. Curve 510 represents the deposition profile for an evaporation source that would have only one full-length operating heating element, for example the evaporation source 200 of FIG. 3A-3D where only heating rods 8, 9, 10 would be switched on but where side heaters 20, 30 would remain switched off. Curve 510 therefore represents a deposition profile with a relatively large amount deposited towards the centerline of the deposition area, whereas a comparatively lesser amount is deposited towards the edge of the deposition area. Curve 520 represents the deposition profile for an evaporation source according to the main aspect of this invention that would have all heating elements switched on and regulated so as to produce a more uniform deposition profile.

FIGS. 6A-6B present two alternative electrical circuits to power said evaporation sources.

FIG. 6A shows a schematic diagram of an electrical circuit to power the independently regulated electrical heating components of evaporation source 200 represented in FIGS. 1A-1E, 2A-2E, 3A-3C, 4A-4D. Heating elements 20, 10, and 30 are powered via pairs of lines (601, 602), (603, 604), and (605, 606) by power supplies 625, 615, and 635, respectively.

FIG. 6B shows a schematic diagram of a preferred electrical circuit to power the independently regulated electrical heating components of evaporation source 200 represented in FIGS. 1A-1E, 2A-2C, 3A-3C, 4A-4D. In order to reduce the number of electrical cables, heating components 10, 20, 30 share some common lines 602, 603 to connect to their respective electrical power supplies 615, 625, 635. A common line 602 is shared by heating elements 10, 20 to connect to respective power supplies 625, 615. In the same way, line 603 connects resistors 10, 30 to their respective power supplies 615, 635. Each end of the heating element network is supplied by unshared lines 601, 604. More generally, if there are N independently regulated heating components, only N+1 lines are needed to connect to the power supplies.

FIG. 7 shows the block diagram of a control system 300 to regulate the vapor deposition process. The "Desired Deposition Parameters" block 310 represents values set by an operator via a user interface. The "Desired Deposition Parameters" block 310 may include desired evaporation source temperature values but more preferably, in the context of a complete evaporation system comprising multiple evaporation sources, desired thickness and relative composition distribution of the material deposited on the substrate. The "Sensors" block 320 therefore represents data acquired not only from temperature sensors 71, 72, 73, but also from other sensors that can for example measure the thickness and relative composition distribution of the material deposited on the substrate. The "Deposition System" block 330 represents the system that incorporates at least one evaporation source 200. The "Controller" block 340 represents a real-time control computation that uses the difference between values set in the "Desired Deposition Parameters" block 310 and values acquired by the "Sensors" block 320 to compute commands for the "Deposition System" block 330, such as commands to the electrical power supplies of heating elements 10, 20, 30.

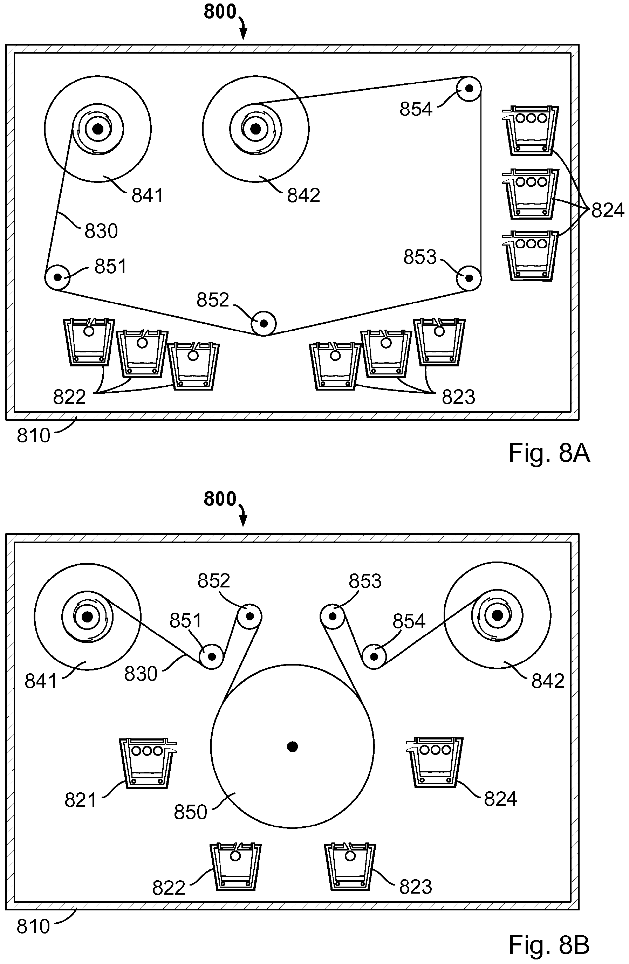

FIGS. 8A-8B show two exemplary embodiments of vapor deposition systems to illustrate how the evaporation sources may be used.

FIG. 8A shows a frontal cross section of a free span roll-to-roll vapor deposition system 800. Vacuum deposition chamber 810 encloses three sets of three evaporation sources 822, 823, 824 selected from the embodiments presented in FIGS. 1A to 4D, namely FIGS. 1E and 4D. Web 830, for example made of polyimide or stainless steel, departs pay-off roll 841 and gets coated by sets of evaporation sources 822, 823, 824 as it travels between tensioning rolls 851, 852, 853, 854, respectively, until it gets rolled-up by take-up roll 842. Sets of evaporation sources 822 and 823 are staged so as to follow the slope of web 830. Set of evaporation sources 824 is staged vertically to match the vertical path of web 830 between tensioning rolls 853 and 854.

Vacuum deposition chamber 810 exhibits a vacuum higher than 10-4 Pa, preferably higher than 10-5, more preferably higher than 10-6 before the start of the coating evaporation process.

FIG. 8B shows a cross section of a drum-based roll-to-roll vapor deposition system 800. Vacuum deposition chamber 810 encloses four evaporation sources 821, 822, 823, 824 selected from the embodiments presented in FIGS. 1A to 4D, namely FIGS. 1E and 4D. Web 830 departs pay-off roll 841, passes tensioning rolls 851, 852 and gets coated by evaporation sources 821, 822, 823, 824 as it is carried against deposition drum 850. Web 830 then continues to tensioning rolls 853, 854 until it gets rolled-up by take-up roll 842. Evaporation sources 821, 822, 823, 824 are staged around deposition drum 850 so as to follow its curvature.

The exemplary embodiments represented in the present disclosure offer a number of advantages for vapor deposition, especially in the context of large area or roll-to-roll deposition, with respect to deposition regulation and quality as well as space and energy savings.

A first advantage results from the use of at least three independently regulated heaters along the evaporation source's length to solve the problem of uneven spatial distribution of the deposited material. Deposition with conventional crucibles ordinarily exhibits a decay of evaporated material deposition profile towards the extremities of the crucible's long axis. The decay is ordinarily compensated for a set point by supplying more heat to the crucible and possibly adapting the longitudinal distribution of nozzle sizes to achieve a desired deposition profile. The benefit of using independently regulated heaters at said extremities is that the resulting deposition profile is more uniform at less energy expense while being easily adaptable via regulation of the independent power supplies.

Also, depletion of material in conventional evaporation sources usually results in changes in the deposition profile. A further advantage of this disclosure is that the heat needed to produce a desired deposition profile can be tuned as the material to be evaporated depletes within the evaporation source or as the heat shields experience changes in their properties. Independent adjustments of the heat produced by the heating elements therefore regulate the evaporation profile. Furthermore, said adjustments prevent the onset of unwanted vapor flow along the crucible's long axis.

In the context of an installation within a vacuum deposition chamber where various devices such as shields or even adjacent evaporation sources installed as an array may temporarily affect a given source's thermal characteristics, the ability to continuously regulate the evaporation profile is especially beneficial for vapor deposition onto large substrates, for example roll-to-roll webs 0.5 meters wide or more, or also glass substrates larger than 0.5 meters in width or length. It then becomes possible to advantageously integrate an evaporation sources feedback control function as part of an evaporation source system. Said feedback control function would at least use temperatures measured by the evaporation source's temperature sensors and possibly also measurements of the material deposited onto the substrate.

The need for compact and closely integrated arrays of evaporation sources is an incentive towards reducing the number of power lines and FIG. 6B therefore presents an advantageous cabling solution to electrically connect heating elements to power supplies. Furthermore, using shared power lines may, under some conditions, enable to reduce the electrical current flowing through some of the lines, thereby further simplifying the cabling between heating elements and power supplies.

An advantage of placing the heating assembly directly above the material to be evaporated is that the surface where evaporation occurs is heated first, thereby permitting a faster response of the evaporation flux to changes in temperature of the heating assembly. Energy may then be saved thanks to reduced thermal inertia of the combined heating assembly and molten material system.

Furthermore, placing the heating assembly mainly within the crucible rather than outside is beneficial to reduce the evaporation source's volume. This is especially advantageous for use within vacuum deposition chambers where several evaporation sources might be used within a restricted volume. For example in the context of a co-evaporation vacuum deposition chamber, it is advantageous to have evaporation sources arranged in parallel and close to each other. Also, the coaxial configuration of the heating assembly presented in the embodiments of FIGS. 1 and 2 reduces the complexity of external wiring needed to power the heating elements in comparison to configurations found in prior art. Benefits of this reduction in wiring are increased overall reliability and reduction of assembly cost.

Another advantage of the source's design is that the crucible and its lid can feature joining lips to channel and direct vapor leaks away from heat shields. Said shields, optionally placed around the crucible and against the lid, insulate the source and therefore reduce the amount of heat radiated to adjacent objects. However, said shields may see their insulating properties diminished if material deposits onto them, hence the design of the extended joining lips to reduce the possibility of material depositing onto the shields.

Finally, placing the heating assembly directly under the lid has several combined advantages: the heating assembly blocks the line of sight between the melt within the crucible and the deposition substrate, therefore preventing detrimental spits of molten material from the crucible towards the substrate; the lid is also heated preferably to a higher temperature than the crucible by the heating assembly, therefore providing a simple way to prevent the formation of condensed material droplets that could either clog the nozzles or fall onto the heating element, thereby creating spitting, or fall further into the molten material and create internal splashes that may be detrimental to the uniformity of the deposition. Said placement of the heating assembly in effect provides a so-called "hot lip source" without requiring the addition of a lip heater. Furthermore, the embodiments presented in FIGS. 1A-4D show that lip heating and line of sight obstruction can be effective both when the nozzles are above or to the side of the heating assembly.

In order to depose thin CIGS films onto a flexible polymer foil (polyimide), a roll-to roll vapor deposition system (800) for the deposition of thin CIGS films on a thin web (830) has been actually built, comprising a vacuum deposition chamber (810) enclosing at least three evaporation sources (822, 823, 824) according to the invention, containing respectively In, Ga and Cu, whereby web (830), made of polyimide foil, departs a pay-off roll (841) and gets coated by said evaporation sources (822, 823, 824) as it travels between tensioning rolls (851, 852, 853, 854) until it gets rolled-up by take-up roll (842).

With such an equipment a 2.5 micrometer thin CIGS film has been deposited onto the flexible polymer substrate. According to such a method for the deposition of thin CIGS films on a thin web (830) with a roll-to roll vapor deposition system (800) comprising a vacuum deposition chamber (810) enclosing at least three evaporation sources (822, 823, 824) according to the invention, containing respectively In, Ga and Cu, the web (830), made of polymer foil, departs a pay-off roll (841), gets coated with a thin CIGS film by said evaporation sources (822, 823, 824) as it travels between tensioning rolls (851, 852, 853, 854) until it gets rolled-up by take-up roll (842).

Details of the performed process can be found in US 8 927 051, WO 2014/097112 and EP 2 647 033.

Photovoltaic cells and photovoltaic modules for the conversion of solar energy into electrical energy comprising said thin CIGS film deposited on a thin web (830), specifically a polyimide foil, had been manufactured and had exhibited an efficiency between 12 and 16%.

Details of the production method can be found in WO2015/1144498, US 8 928 105 and WO 2016/108079 .

## Claims

1. A linear evaporation source apparatus (200) for atomic vapor deposition of metal atoms suited for the production of CIGS thin films, comprising at least one elongated horizontal crucible (50) for containing, up to a given level in the crucible (50), material (55) to be melted and evaporated, and a heater assembly (100) comprising at least three electrical heating elements (10, 20, 30),
**characterized in that:**
(a) each electrical heating element (10, 20, 30) is supplied by electrical lines arranged to enable independent regulation of said heating elements and wherein for N heating elements (10, 20, 30) there are at least N+1 supply lines;
(b) at least one of the heating elements (10) constitutes a principal heating element that is positioned inside the volume of the crucible (50), and extends along and parallel to the longest centerline of the crucible (50), above the level of material (55) to be evaporated;
(c) at least one further heating element (20, 30) is positioned inside or outside the crucible (50) at each end of the longest centerline of the crucible (50) and at each end of said principal heating element (10), so as to achieve a homogeneous temperature distribution and evaporation flux along the longest centerline of the crucible (50);
the principal heating element (10) and at least one further heating element (20, 30) are axially aligned and at least one electrical contact of one of said heating elements passes through and is parallel to the axis of symmetry formed by the shape of one of said heating elements (10, 20, 30); and
the at least three electrical heating elements (10, 20, 30) are coaxial.

2. The apparatus according to Claim 1 wherein the crucible (50) is closed by at least one lid (60) and/or wherein the crucible (50) contains up to a given level in the crucible (50) In, Ga or Cu to be melted and evaporated.

3. The apparatus according to Claims 1 or 2 wherein there is no line of sight from outside the evaporation source apparatus (200) to the material to be evaporated (55) through the nozzles (65), said line of sight being obstructed by the heating element assembly (100).

4. The apparatus according to any one of Claims 1 to 3 wherein at least one heating element (10, 20, 30) that is positioned inside the volume of the evaporation source apparatus (200) is supported at least one location that is not part of one of the faces through which the longest centerline of the crucible (50) passes.

5. The apparatus according to any one of Claims 1 to 4 wherein at least one heating element (10, 20, 30) is an electrically heatable rod made of an electrically-conductive and heat-resistant material, in particular tantalum, graphite, tungsten, or molybdenum.

6. The apparatus according to any one of Claims 1 to 5 wherein at least one heating element (10, 20, 30) is an electrically heatable coil made of an electrically-conductive and heat-resistant material, in particular tantalum, graphite, tungsten, or molybdenum.

7. The apparatus according to any one of Claims 1 to 6 wherein at least two heating elements (10, 20, 30) are separated from each other by electrical insulators (25, 35) made of refractory material.

8. The apparatus according to any one of Claims 1 to 7 wherein the crucible (50) contains at least one temperature sensor (71, 72, 73) for each independently-regulated heating element (10, 20, 30), said temperature sensor (71, 72, 73) being positioned against a part of the crucible (50) that is adjacent to a volume of material to be evaporated (55) that is heated by the respective closest heating element (10, 20, 30).

9. The apparatus according to Claim 8 wherein the crucible (50) comprises at least one temperature sensor channel (52) for receiving at least one temperature sensor (71, 72, 73) such that said temperature sensor channel (52) is positioned under a part of the crucible (50) that is adjacent to a volume of material to be evaporated (55), the temperature sensor channel (52) having an opening located on at least one of the faces of the apparatus through which the longest centerline of crucible (50) passes.

10. The apparatus according to any one of Claims 1 to 9 wherein the heating elements (10, 20, 30) are independently controllable by a control system (300) in response to information acquired from at least one temperature sensor (71, 72, 73).

11. A roll-to roll vapor deposition system (800) suited for the deposition of thin CIGS films on a thin web (830) comprising a vacuum deposition chamber (810) enclosing at least three evaporation sources (822, 823, 824) according to any of the preceding claims containing respectively In, Ga and Cu, whereby web (830), for example made of polymer or metal foil, departs a pay-off roll (841) and gets coated by said evaporation sources (822, 823, 824) as it travels between tensioning rolls (851, 852, 853, 854) until it gets rolled-up by take-up roll (842).

12. Method for the deposition of thin CIGS films on a thin web (830) with a roll-to roll vapor deposition system (800) comprising a vacuum deposition chamber (810) enclosing at least three evaporation sources (822, 823, 824) according to any of the preceding claims 1 to 10 containing respectively In, Ga and Cu, **characterized in that** the web (830), for example made of polymer or metal foil, departs a pay-off roll (841), gets coated with a thin CIGS film by said evaporation sources (822, 823, 824) as it travels between tensioning rolls (851, 852, 853, 854) until it gets rolled-up by take-up roll (842).

## Patentansprüche

1. Lineare Verdampfungsquellenvorrichtung (200) für die atomare Dampfabscheidung von Metallatomen, die für die Herstellung von CIGS-Dünnschichten geeignet ist, mit mindestens einem länglichen horizontalen Tiegel (50), um bis zu einem gegebenen Niveau in dem Tiegel (50), ein zu schmelzendes und zu verdampfendes Material (55) zu enthalten, und einer Heizanordnung (100), die mindestens drei elektrische Heizelemente (10, 20, 30) umfasst,
**dadurch gekennzeichnet, dass** :
(a) jedes elektrische Heizelement (10, 20, 30) durch elektrische Leitungen versorgt wird, die so angeordnet sind, dass sie eine unabhängige Regelung der Heizelemente ermöglichen, und wobei für N Heizelemente (10, 20, 30) mindestens N+1 Versorgungsleitungen vorhanden sind ;
(b) mindestens eines der Heizelemente (10) ein Hauptheizelement bildet, das innerhalb des Volumens des Tiegels (50) positioniert ist und sich entlang und parallel zu der längsten Achse des Tiegels (50) über dem Niveau des zu verdampfenden Materials (55) erstreckt;
(c) mindestens ein weiteres Heizelement (20, 30) innerhalb oder außerhalb des Tiegels (50) an jedem Ende der längsten Achse des Tiegels (50) und an jedem Ende des Hauptheizelements (10) positioniert ist, um eine homogene Temperaturverteilung und einen homogenen Verdampfungsfluss entlang der längsten Achse des Tiegels (50) zu erzielen; das Hauptheizelement (10) und mindestens ein weiteres Heizelement (20, 30) axial ausgerichtet sind und mindestens ein elektrischer Kontakt eines der Heizelemente durch die Symmetrieachse, die durch die Form eines der Heizelemente (10, 20, 30) gebildet wird, verläuft und parallel zu dieser ist;
und die mindestens drei elektrischen Heizelemente (10, 20, 30) koaxial sind.

2. Vorrichtung nach Anspruch 1, bei der der Tiegel (50) durch mindestens einen Deckel (60) verschlossen ist und/oder bei der der Tiegel (50) bis zu einem bestimmten Pegel im Tiegel (50) In, Ga oder Cu enthält, das geschmolzen und verdampft werden soll.

3. Vorrichtung nach Anspruch 1 oder 2, wobei es keine Sichtlinie von außerhalb der Verdampfungsquellenvorrichtung (200) durch die Düsen (65) zu dem zu verdampfenden Material (55) gibt, wobei die Sichtlinie durch die Heizelementanordnung (100) versperrt ist.

4. Vorrichtung nach einem der Ansprüche 1 bis 3, wobei mindestens ein Heizelement (10, 20, 30), das innerhalb des Volumens der Verdampfungsquellenvorrichtung (200) positioniert ist, an mindestens einer Stelle abgestützt ist, die nicht Teil einer der Flächen ist, durch die die längste Achse des Tiegels (50) verläuft.

5. Vorrichtung nach einem der Ansprüche 1 bis 4, bei der mindestens ein Heizelement (10, 20, 30) ein elektrisch beheizbarer Stab aus einem elektrisch leitfähigen und hitzebeständigen Material ist, insbesondere Tantal, Graphit, Wolfram oder Molybdän.

6. Vorrichtung nach einem der Ansprüche 1 bis 5, bei der mindestens ein Heizelement (10, 20, 30) eine elektrisch beheizbare Spule aus einem elektrisch leitenden und hitzebeständigen Material, insbesondere Tantal, Graphit, Wolfram oder Molybdän, ist.

7. Vorrichtung nach einem der Ansprüche 1 bis 6, bei der mindestens zwei Heizelemente (10, 20, 30) durch elektrische Isolatoren (25, 35) aus feuerfestem Material voneinander getrennt sind.

8. Vorrichtung nach einem der Ansprüche 1 bis 7, wobei der Tiegel (50) mindestens einen Temperatursensor (71, 72, 73) für jedes unabhängig geregelte Heizelement (10, 20, 30) enthält, wobei der Temperatursensor (71, 72, 73) gegen einen Teil des Tiegels (50) positioniert ist, der an ein Volumen von zu verdampfendem Material (55) angrenzt, das von dem nächstgelegenen jeweiligen Heizelement (10, 20, 30) erhitzt wird.

9. Vorrichtung nach Anspruch 8, wobei der Tiegel (50) mindestens einen Temperatursensorkanal (52) zur Aufnahme mindestens eines Temperatursensors (71, 72, 73) umfasst, so dass der Temperatursensorkanal (52) unter einem Teil des Tiegels (50) positioniert ist, der an ein Volumen von zu verdampfendem Material (55) angrenzt, wobei der Temperatursensorkanal (52) eine Öffnung aufweist, die auf mindestens einer der Seiten der Vorrichtung angeordnet ist und durch die die längste Achse des Tiegels (50) verläuft.

10. Vorrichtung nach einem der Ansprüche 1 bis 9, wobei die Heizelemente (10, 20, 30) als Reaktion auf Informationen, die von mindestens einem Temperatursensor (71, 72, 73) erfasst werden, von einem Steuersystem (300) unabhängig gesteuert werden können.

11. Rolle-zu-Rolle-Dampfabscheidungssystem (800), das für die Abscheidung von CIGS-Dünnschichten auf einer dünnen Bahn (830) geeignet ist, mit einer Vakuumabscheidungskammer (810), die mindestens drei Verdampfungsquellen (822, 823, 824) nach einem der vorhergehenden Ansprüche einschließt, die jeweils In, Ga und Cu enthalten, so dass die Bahn (830), die beispielsweise aus einer Polymer- oder Metallfolie besteht, eine Abwickelrolle (841) verlässt und mit den Verdampfungsquellen (822, 823, 824) beschichtet wird, während sie sich zwischen den Spannrollen (851, 852, 853, 854) bewegt, bis sie von der Aufwickelrolle (842) aufgewickelt wird.

12. Verfahren zur Abscheidung von CIGS-Dünnschichten auf einer dünnen Bahn (830) mit einem Rolle-zu-Rolle-Dampfabscheidungssystem (800), das eine Vakuumabscheidungskammer (810) mit mindestens drei Verdampfungsquellen (822, 823, 824) nach einem der vorhergehenden Ansprüche 1 bis 10 umfasst, die jeweils In, Ga und Cu enthalten, **dadurch gekennzeichnet, dass** die Bahn (830), die beispielsweise aus einer Polymer- oder Metallfolie besteht, eine Abwickelrolle (841) verlässt und durch die Verdampfungsquellen (822, 823, 824) mit einer dünnen CIGS-Schicht beschichtet wird, während sie sich zwischen Spannrollen (851, 852, 853, 854) bewegt, bis sie von einer Aufwickelrolle (842) aufgewickelt wird.

## Revendications

1. Dispositif de source d'évaporation linéaire (200) pour le dépôt atomique en phase vapeur d'atomes métalliques adapté à la production de couches minces CIGS, comprenant au moins un creuset horizontal allongé (50) pour contenir, jusqu'à un niveau donné dans le creuset (50), un matériau (55) à fondre et à évaporer, et un ensemble chauffant (100) comprenant au moins trois éléments chauffants électriques (10, 20, 30),
**caractérisé en ce que** :
(a) chaque élément chauffant électrique (10, 20, 30) est alimenté par des lignes électriques agencées pour permettre une régulation indépendante desdits éléments chauffants et dans lequel pour N éléments chauffants (10, 20, 30) il y a au moins N+1 lignes d'alimentation ;
(b) au moins un des éléments chauffants (10) constitue un élément chauffant principal qui est positionné à l'intérieur du volume du creuset (50) et s'étend le long et parallèlement à l'axe le plus long du creuset (50) au-dessus du niveau de matière (55) à évaporer ;
(c) au moins un autre élément chauffant (20, 30) est positionné à l'intérieur ou à l'extérieur du creuset (50) à chaque extrémité de l'axe le plus long du creuset (50) et à chaque extrémité dudit élément chauffant principal (10), de manière à obtenir une distribution de température et un flux d'évaporation homogènes le long de l'axe le plus long du creuset (50) ;
l'élément chauffant principal (10) et au moins un autre élément chauffant (20, 30) sont alignés axialement et au moins un contact électrique d'un desdits éléments chauffants traverse et est parallèle à l'axe de symétrie formé par la forme d'un desdits éléments chauffants (10, 20, 30); et les au moins trois éléments chauffants électriques (10, 20, 30) sont coaxiaux.

2. Dispositif selon la revendication 1 dans lequel le creuset (50) est fermé par au moins un couvercle (60) et/ou dans lequel le creuset (50) contient jusqu'à un niveau donné dans le creuset (50) In, Ga ou Cu destiné à être fondu et évaporé.

3. Dispositif selon les revendications 1 ou 2, dans lequel il n'y a pas de ligne de visée depuis l'extérieur du dispositif de source d'évaporation (200) jusqu'au matériau à évaporer (55) à travers les buses (65), ladite ligne de visée étant obstruée par l'ensemble d'éléments chauffant (100).

4. Dispositif selon l'une quelconque des revendications 1 à 3, dans lequel au moins un élément chauffant (10, 20, 30) qui est positionné à l'intérieur du volume du dispositif de source d'évaporation (200) est supporté à au moins un emplacement qui ne fait pas partie d'une des faces par lesquelles passe l'axe le plus long du creuset (50).

5. Dispositif selon l'une quelconque des revendications 1 à 4 dans lequel au moins un élément chauffant (10, 20, 30) est une tige chauffable électriquement en un matériau électriquement conducteur et résistant à la chaleur, notamment du tantale, du graphite, du tungstène ou du molybdène.

6. Dispositif selon l'une quelconque des revendications 1 à 5 dans lequel au moins un élément chauffant (10, 20, 30) est une bobine chauffable électriquement constituée d'un matériau électriquement conducteur et résistant à la chaleur, notamment du tantale, du graphite, du tungstène ou du molybdène.

7. Dispositif selon l'une quelconque des revendications 1 à 6 dans lequel au moins deux éléments chauffants (10, 20, 30) sont séparés l'un de l'autre par des isolants électriques (25, 35) en matériau réfractaire.

8. Dispositif selon l'une quelconque des revendications 1 à 7, dans lequel le creuset (50) contient au moins un capteur de température (71, 72, 73) pour chaque élément chauffant régulé indépendamment (10, 20, 30), ledit capteur de température (71, 72, 73) étant positionné contre une partie du creuset (50) qui est adjacente à un volume de matériau à évaporer (55) qui est chauffé par l'élément chauffant respectif le plus proche (10, 20, 30).

9. Dispositif selon la revendication 8, dans lequel le creuset (50) comprend au moins un canal de capteur de température (52) pour recevoir au moins un capteur de température (71, 72, 73) de sorte que ledit canal de capteur de température (52) est positionné sous une partie du creuset (50) qui est adjacente à un volume de matériau à évaporer (55), le canal de capteur de température (52) ayant une ouverture située sur au moins une des faces du dispositif à travers laquelle l'axe le plus long du creuset (50) passe.

10. Dispositif selon l'une quelconque des revendications 1 à 9, dans lequel les éléments chauffants (10, 20, 30) peuvent être commandés indépendamment par un système de commande (300) en réponse à des informations acquises à partir d'au moins un capteur de température (71, 72, 73).

11. Système de dépôt en phase vapeur rouleau à rouleau (800) adapté au dépôt de couches minces CIGS sur une nappe mince (830) comprenant une chambre de dépôt sous vide (810) renfermant au moins trois sources d'évaporation (822, 823, 824) selon l'une quelconque des revendications précédentes contenant respectivement In, Ga et Cu, de sorte que la nappe (830), par exemple constituée d'une feuille de polymère ou de métal, quitte un rouleau de dévidage (841) et est revêtue par lesdites sources d'évaporation (822, 823, 824) lorsqu'elle se déplace entre les rouleaux tendeurs (851, 852, 853, 854) jusqu'à ce qu'elle soit enroulée par le rouleau enrouleur (842).

12. Méthode pour la deposition de couches minces CIGS sur une nappe mince (830) avec un système de dépôt en phase vapeur rouleau à rouleau (800) comprenant une chambre de dépôt sous vide (810) renfermant au moins trois sources d'évaporation (822, 823, 824) selon l'une quelconque des revendications précédentes 1 à 10 contenant respectivement In, Ga et Cu, **caractérisé en ce que** la nappe (830), par exemple constituée d'une feuille de polymère ou de métal, quitte un rouleau de dévidage (841), est revêtue d'une couche mince CIGS par lesdites sources d'évaporation (822, 823, 824) lorsqu'elle se déplace entre des rouleaux tendeurs (851, 852, 853, 854) jusqu'à ce qu'elle soit enroulée par un rouleau enrouleur (842).
